# EUROPÄISCHE PATENTSCHRIFT

(11) **EP 0 382 923 B1**
(45) Veröffentlichungstag und Bekanntmachung des Hinweises auf die Patenterteilung: **18.05.1994**
(21) Anmeldenummer: 89123028.6
(22) Anmeldetag: 13.12.1989
(51) Int. Cl.: H01R 13/66, G01R 31/36

(54) **Elektrischer Steckverbinder**
Electrical connector
Connecteur électrique

(30) Priorität: 16.12.1988 DE 8815659 U
(43) Veröffentlichungstag der Anmeldung: 22.08.1990
(73) Patentinhaber: HAGEN BATTERIE AG, D-59494 Soest (DE)
(72) Erfinder: Kirchner, Hermann Erich Karl, D-4772 Bad Sassendorf (DE)
(74) Vertreter: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) Entgegenhaltungen:
- DE-A- 3 808 559
- US-A- 2 782 357
- US-A- 3 983 407

## Beschreibung

Die Erfindung betrifft einen Steckverbinder zur Verbindung einer Fahrzeugbatterie mit insbesondere dem Fahrzeug-Bordnetz und einem Batterieüberwachungs- und/oder -entladezustandsanzeigegerät, mit einem batterieseitigen, durch einen Stecker oder eine Steckdose gebildeten Batterieverbinderteil und einem fahrzeugseitigen, durch eine Steckdose bzw. einen Stecker gebildeten Fahrzeugverbinderteil, wobei die beiden Verbinderteile zum Anschluß des Bordnetzes an die beiden Batterieklemmen jeweils mit zwei Hauptkontakten versehen sind.

Zur Kontrolle und Überwachung des Entladezustands der Fahrzeugbatterie sind in den meisten batterieelektrisch angetriebenen Fahrzeugen Batterieüberwachungs- und/oder -entladezustandsanzeigegeräte vorgesehen. Obwohl diese Geräte vielfältige bauliche Unterschiede aufweisen und insbesondere mit den unterschiedlichsten Meßeinrichtungen ausgestattet sein können, bildet bei einem Großteil der verwendeten Meßeinrichtungen der Verlauf der Entladespannung während der Entladung der Batterien eines der wesentlichen Meßkriterien.

Werden zwar kapazitätsgleiche, jedoch baulich unterschiedliche Batterien mit verschiedenen Innenwiderständen und damit voneinander abweichenden Spannungslagen während der Entladung alternativ oder abwechselnd in ein und demselben Fahrzeug eingesetzt, so können sich aufgrund einer Fehlanpassung des betreffenden Batterieüberwachungs- und/oder -entladezustandsanzeigegeräts fehlerhafte Meßergebnisse ergeben. Die erforderliche genaue Anpassung der Überwachungs- und -entladezustandsanzeigegeräte ist nicht in jedem Falle ohne weiteres möglich. Überdies ist die mit einem jeden Austausch eines Batterietyps durch einen anderen von neuem erforderliche Eichung der Geräte relativ aufwendig. Schließlich muß auch stets damit gerechnet werden, daß bei einer anstehenden Wartung die Neueichung völlig vergessen oder eine falsche Eichung vorgenommen wird.

Die genannten Fehlerquellen können beispielsweise bei einem alternativen Einsatz von PzS- oder CSM-Batterien und dergleichen sowie wartungsfreien Batterien auftreten.

So weisen beispielsweise Hochleistungs-CSM-Batterien mit einem mit Blei überzogenen Kupferstreckmetallgitter als negative Elektrode bei durchschnittlichen Betriebsbedinungen eine mittlere Entladespannung auf, die um etwa 0,05 Volt/Zelle höher ist als bei PzS-Batterien, d.h. bei normalen Bleiakkumulatoren mit einem herkömmlichen Bleigitter als negative Elektrode.

Ist demnach beispielsweise ein Batterieentladezustandsanzeiger auf PzS-Batterien geeicht, so wird beim Einsatz einer CSM-Batterie eine zu geringe Entladungstiefe angezeigt. D.h., tatsächlich liegt eine tiefere Entladung vor. Ist der Entladezustandsanzeiger demgegenüber auf CSM-Batterien geeicht, so wird beim Einsatz einer PzS-Batterie eine zu große Entladungstiefe angezeigt. D.h. tatsächlich liegt eine geringere Entladungstiefe vor.

Der Erfindung liegt die Aufgabe zugrunde, einen Steckverbinder der eingangs genannten Art zu schaffen, durch den auf äußerst einfache und zuverlässige Weise praktisch automatisch stets eine optimale Anpassung des verwendeten Batterieüberwachungs- und/oder -entladezustandsanzeigegeräts an unterschiedliche Batterietypen gewährleistet ist.

Die Aufgabe wird nach der Erfindung dadurch gelöst, daß das Batterieverbinderteil mehrere Pilotkontakte aufweist, denen eine gleiche Anzahl von Pilotkontakten des Fahrzeugverbinderteils zugeordnet ist, daß miteinander in Kontakt tretende Pilotkontaktpaare in Verbindungszweigen liegen, die zum Ausgleich unterschiedlicher Entladespannungen verschiedener Batterietypen unterschiedliche Impedanzwerte aufweisen, daß sämtliche dem Fahrzeugverbinderteil zugeordnete Verbindungszweigenden mit einer gemeinsamen Anschlußleitung für das Batterieüberwachungs- und/oder -entladezustandsanzeigegerät verbunden sind, und daß ein jeweiliger Verbindungszweig durch die Verbindung des betreffenden, dem Batterieverbinderteil zugeordneten Verbindungszweigendes mit einem ersten der beiden Hauptkontakte des Batterieverbinderteils bzw. der zugeordneten Batterieklemme ausgewählt ist.

Aufgrund dieser Ausbildung treten in den verschiedenen Verbindungszweigen, von denen jeweils nur einer durch Anschluß an einen der beiden Hauptkontakte des Batterieverbinderteils aktiviert ist, unterschiedliche Spannungsabfälle auf. Die Differenz der Spannungsabfalle entspricht der Differenz der mittleren Batterieentladespannungen verschiedener Batterien unterschiedlicher Bauart.

Werden z. B. PzS-Batterien und CSM-Batterien alternativ im Fahrzeug eingesetzt, so kann z.B. der Entladezustandsanzeiger auf den niedrigeren, mittleren Entladespannungsverlauf der PzS-Batterie geeicht sein. Da die Meßanschlußleitung des Entladeanzeigers nunmehr direkt zum Fahrzeugverbinderteil verlegbar ist, kann zur Kompensation des zuvor aufgetretenen Spannungsabfalls auf der im Fahrzeug verlegten Entladeleitung eine entsprechend geringe Impedanz für den der PzS-Batterie zugeordneten Verbindungszweig gewählt werden. Beim Anschluß z.B. einer CSM-Batterie mit einer höheren mittleren Entladespannung erfolgt der Anschluß über ein anderes Pilotkontaktpaar und den diesem zugeordneten Verbindungszweig mit entsprechend höherem Spannungabfall.

Erfindungsgemäß ergibt sich demnach für das Batterieüberwachungs- und -meßsystem auch für unterschiedliche Batterietypen eine nahezu unveränderte Meßeingangsspannung, so daß in jedem Falle eine genaue und zuverlassige Aussage über den Entladezustand der jeweiligen Batterie möglich ist.

Dadurch, daß die entsprechenden Pilotkontakte des einer jeweiligen Batterie zugeordneten Batterieverbinderteils mit dem betreffenden Hauptkontakt bzw. der betreffenden Batterieklemme verbunden sind, ergibt sich für jeden Batterietyp eine Art Codierung, durch welche automatisch stets der richtige Verbindungszweig und damit der zur Kompensation der unterschiedlichen mittleren Entladespannungen erforderliche Spannungsabfall festgelegt ist. Eine jeweilige Meßbereichsumschaltung kann demnach entfallen.

Vorzugsweise ist eine weitere Anschlußleitung für das Batterieüberwachungs- und/oder -entladezustandsanzeigegerät mit dem dem zweiten Hauptkontakt des Batterieverbinderteils zugeordneten Hauptkontakt des Fahrzeugverbinderteils verbunden. Damit ist das Batterieüberwachungs- und/oder -entladezustandsanzeigegerät nach hergestelltem Steckkontakt mit einem Eingang direkt mit der einen Batterieklemme und mit dem anderen Eingang über den ausgewählten, einen betreffenden Spannungsabfall hervorrufenden Verbindungszweig mit der anderen Batterieklemme verbunden.

Der erste Hauptkontakt des Batterieverbinderteils kann mit der positiven Batterieklemme und dessen zweiter Hauptkontakt mit der negativen Batterieklemme verbunden sein.

Gemaß einer bevorzugten Ausfuhrungsvariante sind die unterschiedlichen Impedanzwerte der Verbindungszweige durch eine unterschiedliche Anzahl von jeweils in Durchlaßrichtung hintereinandergeschalteter Dioden bestimmt. Nachdem die betreffenden Verbindungszweige damit in einer Richtung undurchlässig sind, ist eine Selbstentladung über die Pilotkontakte ausgeschlossen.

Vorzugsweise sind z.B. bei einer 80 V-Batterie in einem ersten Verbindungszweig vier Dioden und in einem weiteren Verbindungszweig eine einzige Diode angeordnet. Der Verbindungszweig mit der einen Diode kann beispielsweise einer PzS-Batterie mit niedriger mittlerer Entladespannung zugeordnet sein. Die vorgesehene eine Diode dient zur Kompensation des zuvor aufgetretenen Spannungsabfalls auf der im Fahrzeug verlegten Entladeleitung. Damit wird berücksichtigt, daß die Meßanschlußleitung beispielsweise eines Entladeanzeigers jetzt direkt zum Fahrzeugverbinderteil verlegbar ist. Der die vier Dioden aufweisende Verbindungszweig mit dem entsprechend höheren Spannungsabfall ist beispielsweise einer CSM-Batterie mit einer entsprechend höheren mittleren Entladespannung zugeordnet.

Grundsätzlich können die unterschiedlichen Impedanzwerte der Verbindungszweige jedoch auch durch den Widerstandswert ohmscher Widerstände bestimmt sein.

Die Dioden bzw. Widerstände sind vorteilhafterweise den Pilotkontakten des Fahrzeugverbinderteils nachgeschaltet. In diesem Fall sind diese Dioden bzw. Widerstände zweckmäßigerweise im Fahrzeugverbinderteil integriert. Gemäß einer anderen Ausführungsvariante können diese jedoch auch dem Fahrzeugverbinderteil nachgeschaltet sein.

Gemäß einer anderen praktischen Ausführungsvariante ist vorgesehen, die Dioden bzw. Widerstände den Pilotkontakten des Batterieverbinderteils vorzuschalten. In diesem Fall können die Dioden bzw. Widerstände im Batterieverbinderteil integriert oder diesem vorgeschaltet sein.

Vorzugsweise ist zumindest in eine der zum Batterieüberwachungs- und/oder -entladezustandsanzeigegerät führenden Anschlußleitungen eine Sicherung eingeschaltet, welche zweckmäßigerweise im Fahrzeugverbinderteil integriert ist. Bei den Pilotkontakten des Fahrzeugverbinderteils nachgeschalteten Dioden kann die Sicherung unmittelbar im Anschluß an die Dioden vorgesehen sein, so daß die Meßleitung direkt hinter diesen abgesichert ist, was aufgrund der Querschnittsänderung von der Batterieleitung zur Meßleitung zweckmäßig ist. Auch in diesem Fall können die Dioden wiederum wahlweise im Fahrzeugverbinderteil integriert oder diesem nachgeschaltet sein.

Eine praktische Ausführungsform zeichnet sich dadurch aus, daß das Batterieverbinderteil und das Fahrzeugverbinderteil jeweils nur zwei Pilotkontakte aufweisen. Ein solcher Steckverbinder kann beispielsweise zum alternativen Anschluß von PzS- und CSM-Batterien bestimmt sein.

Bei den Pilotkontakten des Fahrzeugverbinderteils nachgeschalteten Dioden bzw. Widerständen ist der jeweilige Pilotkontakt des Batterieverbinderteils vorzugsweise über eine leitende Brücke oder dergleichen direkt mit dem betreffenden Hauptkontakt des Batterieverbinderteils bzw. der zugeordneten Batterieklemme verbunden.

Die Erfindung wird im folgenden anhand von Ausführungsbeispielen unter Bezugnahme auf die Zeichnung näher beschrieben; in dieser zeigt:
- Fig. 1: eine schematische Darstellung eines einen Stecker sowie eine Steckdose umfassenden Steckverbinders,
- Fig. 2: eine schematische Darstellung der Verschaltung eines Steckverbinders zwischen der Fahrzeugbatterie und einem Batterie-Kontrollgerät,
- Fig. 3: die Darstellung zweier Batteriestecker, wobei der erste für eine CSM- und der zweite für eine PzS-Batterie codiert ist, und
- Fig. 4: einen Fahrzeugstecker.

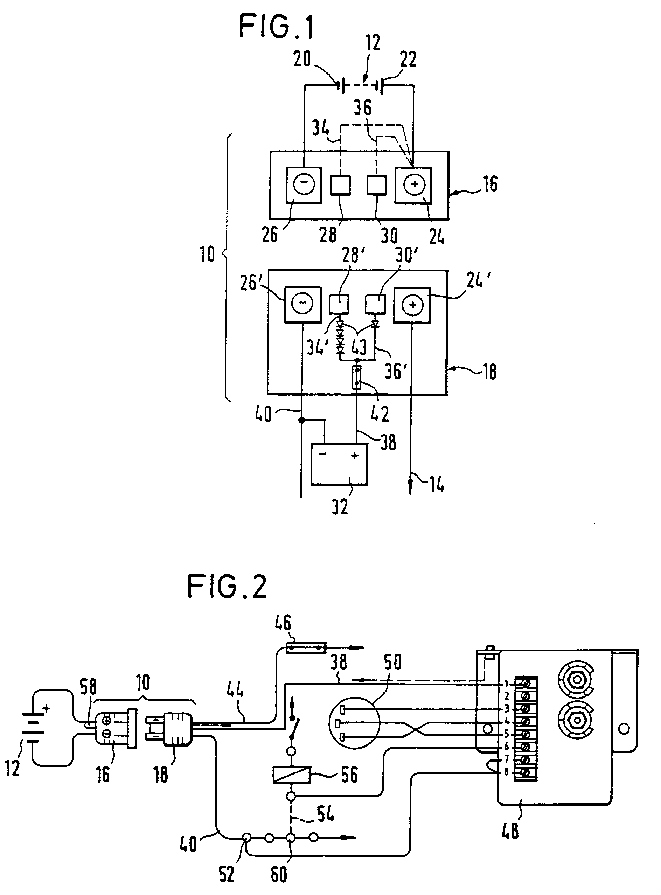

In Fig. 1 ist in schematischer Darstellung ein Steckverbinder 10 zur Verbindung einer Fahrzeugbatterie mit dem Fahrzeug-Bordnetz 14 und einem Batterieüberwachungs- und/oder -entladezustandsanzeigegerät 32 gezeigt.

Der Steckverbinder 10 umfaßt ein batterieseitiges, durch einen Stecker oder eine Steckdose gebildetes Batterieverbinderteil 16 sowie ein fahrzeugseitiges, durch eine Steckdose bzw. einen Stecker gebildetes Fahrzeugverbinderteil 18.

Zum Anschluß des Bordnetzes 14 an die beiden Batterieklemmen 20, 22 sind die beiden Verbinderteile 16, 18 jeweils mit zwei Hauptkontakten 26, 24 bzw. 26′, 24′ versehen. Dabei sind die Hauptkontakte 26, 26′ der negativen Batterieklemme 20 und die Hauptkontakte 24, 24′ der positiven Batterieklemme 22 zugeordnet.

Das Batterieverbinderteil 16 ist mit zwei Pilotkontakten 28, 30 bestückt, denen eine gleiche Anzahl von Pilotkontakten 28′, 30′ des Fahrzeugsverbinderteils 18 zugeordnet ist.

Die miteinander in Kontakt tretenden Pilotkontaktpaare 28, 28′; 30, 30′ liegen jeweils in Verbindungszweigen 34, 34′; 36, 36′, welche zum Ausgleich unterschiedlicher Entladespannungen verschiedener Batterietypen, im vorliegenden Falle CSM- und PzS-Batterien, unterschiedliche Impedanzwerte aufweisen.

Das Batterieüberwachungs- und/oder -entladezustandsanzeigegerät 32 weist zwei Eingänge auf, zu welchen zwei Anschlußleitungen 38, 40 führen. Die eine Anschlußleitung 40 ist direkt mit dem negativen Hauptkontakt 26′ des Fahrzeugverbinderteils 18 verbunden.

Die beiden Verbindungszweige 34, 34′; 36, 36′ sind mit ihrem im Fahrzeugverbinderteil 18 liegenden Ende über eine Sicherung 42 mit der Anschlußleitung 38 für das Batterieüberwachungs- und/oder -entladezustandsanzeigegerät 32 verbunden.

Ein jeweiliger Verbindungszweig 34, 34′ bzw. 36, 36′ ist dadurch ausgewählt, daß der betreffende Pilotkontakt 28 bzw. 30 des Batterieverbinderteils 16 mit dem positiven Hauptkontakt 24 des Batterieverbinderteils 16 bzw. der zugeordneten positiven Batterieklemme 22 verbunden ist. Diese Verbindung kann mittels einer Brücke oder dergleichen erfolgen. Es ist jeweils nur einer der beiden Pilotkontakte 28, 30 mit dem genannten Hauptkontakt 24 verbunden. Im vorliegenden Falle ist bei einem einer CSM-Batterie zugeordneten Batterieverbinderteil 16 der Pilotkontakt 28 mit dem Hauptkontakt 24 verbunden, während bei einem einer PzS-Batterie zugeordneten Batterieverbinderteil 16 der Pilotkontakt 30 mit dem Hauptkontakt 24 in Verbindung steht. Durch den Anschluß des jeweiligen Pilotkontaktes an den Hauptkontakt ergibt sich damit eine Art Codierung für den betreffenden Batterietyp, welche den betreffenden Verbindungszweig 34, 34′ bzw. 36, 36′ mit dem passenden Spannungabfall zur Kompensation der unterschiedlichen mittleren Entladespannungen der verschiedenen Batterietypen festlegt.

Die unterschiedlichen Impedanzwerte der beiden Verbindungszweige 34, 34′; 36, 36′ sind durch eine unterschiedliche Anzahl von im betreffenden Verbindungszweig liegenden Dioden 42 bestimmt. Hierbei liegen im beispielsweise einer CSM-Batterie zugeordneten Verbindungszweig 34, 34′ vier Dioden 42 in Reihe hintereinander, wahrend im anderen, beispielsweise einer PzS-Batterie zugeordneten Verbindungszweig 36, 36′ lediglich eine derartige Diode 42 vorgesehen ist.

Die Dioden 42 sind den Pilotkontakten 28′,30′ des Fahrzeugverbinderteils 18 nachgeschaltet und im Fahrzeugverbinderteil 18 integriert. Die unmittelbar hinter den Dioden 42 liegende, in der Anschlußleitung 38 vorgesehene Sicherung 42 ist ebenfalls im Fahrzeugverbinderteil 18 integriert. Die Meßleitung 38 ist demnach direkt hinter den Dioden 42 abgesichert, was aufgrund der Querschnittsänderung von der Batterieleitung zur Meßleitung erforderlich ist.

Jedem der beiden Pilotkontaktpaare 28, 28′; 30, 30′ bzw. jedem der beiden Pilotkontakte 28′, 30′ des Fahrzeugverbinderteils 18 ist demnach zur Erzeugung unterschiedlicher Spannungabfälle eine unterschiedliche Anzahl von Dioden 42 nachgeschaltet, wobei mit dem Anschluß des einen oder anderen Pilotkontakts 28, 30 an den positiven Hauptkontakt 24 des Batterieverbinderteils 16 der betreffende Spannungsabfall ausgewahlt ist.

Die Differenz der Spannungsabfälle entspricht im vorliegenden Falle der Differenz der mittleren Entladespannungen zweier Batterien gleicher Kapazität jedoch unterschiedlicher Bauart mit unterschiedlichen Innenwiderständen und damit unterschiedlichem mittleren Entladespannungsverlauf. Diese beiden verschiedenen Batterietypen können im vorliegenden Falle beispielsweise PzS-Batterien und CSM-Batterien sein.

Werden beispielsweise derartige PzS-Batterien und CSM-Batterien alternativ im Fahrzeug eingesetzt, so ist z.B. der Entladezustandsanzeiger auf den mittleren Entladespannungsverlauf der die geringere Entladespannung aufweisenden PzS-Batterie geeicht. Da die Anschlußleitung 38 des Batterieüberwachungs- und/oder -entladezustandsanzeigegeräts 32 nunmehr direkt zum Fahrzeugverbinderteil 18 geführt ist, ist zur Kompensation des zuvor aufgetretenen Spannungsabfalls auf der im Fahrzeug verlegten Entladeleitung die eine Diode 42 im Verbindungszweig 36, 36′ vorgesehen, welche dem Pilotkontaktpaar 30, 30′ nachgeschaltet ist. Beim Betrieb einer PzS-Batterie ist der Pilotkontakt 30 mit dem Hauptkontakt 24 des Batterieverbinderteils 16 verbunden, während die Verbindung des Pilotkontakts 28 zu diesem Hauptkontakt 24 unterbrochen ist. Damit wird für die PzS-Batterie der den geringeren Spannungsabfall erzeugende Verbindungszweig 36, 36′ wirksam.

Beim Anschluß z.B. der CSM-Batterie mit der höheren mittleren Entladespannung ist ein Batterieverbinderteil 16 vorgesehen, bei welchem die Verbindung zwischen dem Pilotkontakt 30 und dem Hauptkontakt 24 unterbrochen und der Pilotkontakt 28 mit diesem positiven Hauptkontakt 24 verbunden ist. Damit wird für eine solche CSM-Batterie der einen höheren Spannungsabfall bewirkende Verbindungszweig 34, 34′ wirksam.

Dies bedeutet, daß trotz unterschiedlicher Batterietypen die Meßeingangsspannung für das Batterieüberwachungs- und -meßsystem nahezu unverändert bleibt. Trotz der unterschiedlichen Batteriearten ist demnach stets eine genaue Angabe des jeweiligen Entladezustands möglich.

Dadurch, daß alternativ das Pilotkontaktpaar 28, 28′ bzw. der Pilotkontakt 28 oder das Pilotkontaktpaar 30, 30′ bzw. der Pilotkontakt 30 mit dem positiven Hauptkontakt 24 des Batterieverbinderteils 16 verbunden sind, ergibt sich für die sich in der Bauart unterscheidenden PzS- und CSM-Batterien eine Art Codierung. So ist bei der PzS-Batterie der Pilotkontakt 28 und bei der CSM-Batterie der Pilotkontakt 30 mit dem Hauptkontakt 24 des Batterieverbinderteils 16 bzw. der positiven Batterieklemme 22 verbunden.

Gemäß Fig. 2 ist das an die Fahrzeugbatterie 12 angeschlossene Fahrzeugverbinderteil 16 des Steckverbinders 10 durch eine Steckdose gebildet, wahrend das das Gegenstück bildende Fahrzeugverbinderteil 18 ein Stecker ist.

Das Fahrzeug-Bordnetz ist über zwei Anschlußleitungen 40, 44 mit dem Fahrzeugverbinderteil 18 und über diesen mit den beiden Klemmen der Batterie 12 verbunden. Hierbei führt die Anschlußleitung 40 zu einer ersten Minusklemme 52 des 5A-Fahrzeug-Bordnetzes. In der über den Steckverbinder 10 mit der positiven Klemme der Fahrzeugbatterie 12 verbundenen Anschlußleitung 44 ist eine Sicherung 46 vorgesehen.

Die Anschlußleitung 38 führt wiederum zu einem Anschluß eines Batterieüberwachungs- und/oder -entladezustandsanzeigegeräts, welches im vorliegenden Falle ein Batteriekontrollgerät 48 sowie ein an dieses angeschlossenes Anzeigeinstrument 50 aufweist. An das Batterie-Kontrollgerät 48 ist ferner ein Hubschütz 56 angeschlossen, welches vor der Installation über eine strichpunktiert angedeutete Leitung 54 zunächst an eine weitere Minusklemme 60 des Fahrzeug-Bordnetzes angeschlossen ist.

Das Anzeigeinstrument 50 ist an drei Ausgänge des Batterie-Kontrollgeräts 48 angeschlossen.

Am batterieseitigen Ende des Batterieverbinderteils 16 tritt eine Leiterschleife 58 hervor, welche eine Verbindung zwischen der positiven Batterieklemme und einem betreffenden Pilotkontakt herstellt. Diese Leiterschleife kann zur Anzeige der vorgesehenen Beschaltung markiert sein, z.B. eine entsprechende Farbe aufweisen.

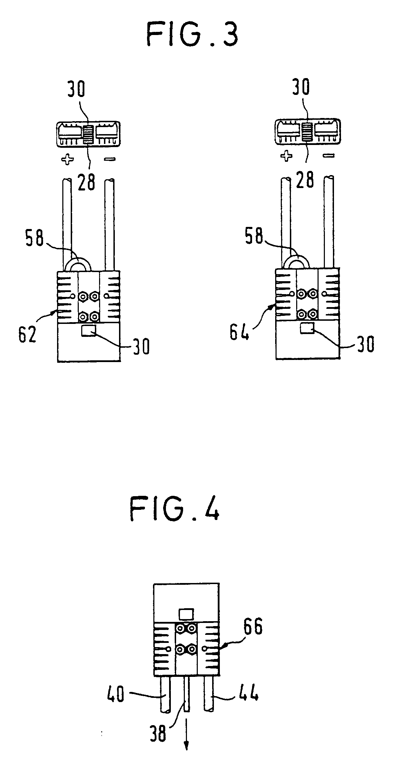

Diese Leiterschleife 58 ist auch bei den beiden in Fig. 3 gezeigten Batteriesteckern 62, 64 erkennbar. Beim linken Batteriestecker 62 handelt es sich um einen einer CSM-Batterie zugeordneten Stecker, während der rechte Batteriestecker 64 einer PzS-Batterie zugeordnet ist. Durch die jeweilige Leiterschleife 58 wird der positive Hauptkontakt bzw. die positive Anschlußklemme der Batterie mit dem einen Pilotkontakt 28 (CSM-Batterie) oder dem anderen Pilotkontakt 30 (PzS-Batterie) verbunden. Während die Leiterschleife 58 des einer CSM-Batterie zugeordneten Batteriesteckers 62 rot markiert ist, ist diese Leiterschleife 58 des einer PzS-Batterie zugeordneten Batteriesteckers 64 schwarz markiert.

Während die Hauptkontakte der Batteriestecker seitlich liegen, sind im vorliegenden Falle die Pilotkontakte 28, 30 übereinander angeordnet.

Die beiden von den Batteriesteckern 62, 64 jeweils wegführenden Hauptleitungen sind mit den beiden Batterieklemmen verbunden.

In Fig. 4 ist ein Fahrzeugstecker 66 gezeigt, welcher die Dioden zur Erzeugung der entsprechenden Spannungsabfälle aufweist. Dieser Fahrzeugstecker 66 ist wiederum mit den drei Anschlußleitungen 40, 44 und 38 verbunden, von denen die Anschlußleitungen 40, 44 zum Anschluß des Bordnetzes an die beiden Batterieklemmen dienen und die Anschlußleitung 38 zum positiven Eingang des Batterieüberwachungs- und/oder -entladezustandsanzeigegeräts führt.

## Patentansprüche

1. Steckverbinder zur Verbindung einer Fahrzeugbatterie (12) mit insbesondere dem Fahrzeug-Bordnetz und einem Batterieüberwachungs- und/oder -entladezustandsanzeigegerät (32), mit einem batterieseitigen, durch einen Stecker oder eine Steckdose gebildeten Batterieverbinderteil (16) und einem fahrzeugseitigen, durch eine Steckdose bzw. einen Stecker gebildeten Fahrzeugverbinderteil (18), wobei die beiden Verbinderteile zum Anschluß des Bordnetzes an die beiden Batterieklemmen jeweils mit zwei Hauptkontakten (26, 26', 24, 24') versehen sind, dadurch **gekennzeichnet,** daß das Batterieverbinderteil (16) mehrere Pilotkontakte (28, 30) aufweist, denen eine gleiche Anzahl von Pilotkontakten (28′, 30′) des Fahrzeugverbinderteils (18) zugeordnet ist, daß miteinander in Kontakt tretende Pilotkontaktpaare (28, 28′; 30, 30′) in Verbindungszweigen (34, 34′; 36, 36′) liegen, die zum Ausgleich unterschiedlicher Entladespannungen verschiedener Batterietypen unterschiedliche Impedanzwerte aufweisen, daß sämtliche dem Fahrzeugverbinderteil (18) zugeordnete Verbindungszweigenden mit einer gemeinsamen Anschlußleitung (38) für das Batterieüberwachungs- und/oder -entladezustandsanzeigegerät (32) verbunden sind, und daß ein jeweiliger Verbindungszweig durch die Verbindung des betreffenden, dem Batterieverbinderteil (16) zugeordneten Verbindungszweigendes mit einem ersten (24) der beiden Hauptkontakte (24, 26) des Batterieverbinderteils bzw. der zugeordneten Batterieklemme (22) ausgewählt ist, wobei insbesondere eine weitere Anschlußleitung (40) für das Batterieüberwachungs- und/oder -entladezustandsanzeigegerät (32) mit dem dem zweiten Hauptkontakt (26) des Batterieverbinderteils (16) zugeordneten Hauptkontakt (26′) des Fahrzeugverbinderteils (18) verbunden ist.

2. Steckverbinder nach Anspruch 1, dadurch **gekennzeichnet,** daß der erste Hauptkontakt (24) des Batterieverbinderteils (16) mit der positiven Batterieklemme (22) und dessen zweiter Hauptkontakt (26) mit der negativen Batterieklemme (20) verbunden ist.

3. Steckverbinder nach Anspruch 1 oder 2, dadurch **gekennzeichnet,** daß die unterschiedlichen Impedanzwerte der Verbindungszweige (34, 34′; 36, 36′) durch eine unterschiedliche Anzahl von jeweils in Durchlaßrichtung hintereinandergeschalteter Dioden (42) bestimmt sind, wobei insbesondere in einem ersten Verbindungszweig (34, 34′) vier Dioden (42) und in einem weiteren Verbindungszweig (36, 36′) eine einzige Diode (42) angeordnet sind.

4. Steckverbinder nach einem der Ansprüche 1 bis 3, dadurch **gekennzeichnet,** daß die unterschiedlichen Impedanzwerte der Verbindungszweige (34, 34′; 36, 36′) durch den Widerstandswert Ohm'scher Widerstände bestimmt sind.

5. Steckverbinder nach einem der vorhergehenden Ansprüche, dadurch **gekennzeichnet,** daß die Dioden (42) bzw. Widerstände den Pilotkontakten (28′, 30′) des Fahrzeugverbinderteils (18) nachgeschaltet sind, wobei insbesondere entweder die Dioden (42) bzw. Widerstände im Fahrzeugverbinderteil (18) integriert sind oder die Dioden (42) bzw. Widerstände dem Fahrzeugverbinderteil (18) nachgeschaltet sind.

6. Steckverbinder nach einem der Ansprüche 1 bis 5, dadurch **gekennzeichnet,** daß die Dioden (42) bzw. Widerstände den Pilotkontakten (28, 30) des Batterieverbinderteils (16) vorgeschaltet sind, wobei insbesondere entweder die Dioden (42) bzw. Widerstände im Batterieverbinderteil (16) integriert sind oder die Dioden (42) bzw. Widerstände dem Batterieverbinderteil (16) vorgeschaltet sind.

7. Steckverbinder nach einem der vorhergehenden Ansprüche, dadurch **gekennzeichnet,** daß zumindest in eine der zum Batterieüberwachungs- und/oder -entladezustandsanzeigegerät (32) führenden Anschlußleitungen (38, 40) eine Sicherung (42) eingeschaltet ist, wobei insbesondere die Sicherung (42) im Fahrzeugverbinderteil (18) integriert ist.

8. Steckverbinder nach einem der vorhergehenden Ansprüche, dadurch **gekennzeichnet,** daß das Batterieverbinderteil (16) und das Fahrzeugverbinderteil (18) jeweils zwei Pilotkontakte (28, 30; 28′, 30′) aufweisen.

9. Steckverbinder nach einem der vorhergehenden Ansprüche, dadurch **gekennzeichnet,** daß bei den Pilotkontakten (28′, 30′) des Fahrzeugverbinderteils (18) nachgeschalteten Dioden (42) bzw. Widerständen der jeweilige Pilotkontakt (28, 30) des Batterieverbinderteils (16) über eine leitende Brücke oder dergleichen direkt mit dem betreffenden Hauptkontakt (24) des Batterieverbinderteils (16) verbunden ist.

## Claims

1. A plug connector for connecting a vehicle battery (12), with, in particular, the vehicle wiring and a battery monitoring and/or state of discharge display apparatus (32), comprising a battery connector part (16) at the battery side and formed by a plug or a socket and a vehicle connector part (18) at the vehicle side formed by a socket or a plug respectively, with the two connector parts being in each case provided with two main contacts (26, 26', 24, 24') for connection of the wiring to the two battery terminals, characterised in that the battery connector part (16) has several pilot contacts (28, 30) with which a like number of pilot contacts (28', 30') of the vehicle connector part (18) is associated; in that pilot contact pairs (28, 28'; 30, 30') which enter into contact with one another lie in connection branches (34, 34'; 36, 36') which have different impedance values to compensate for different discharge voltages of different battery types; in that all connection branches associated with the vehicle connector part (18) are connected to a common connection line (38) for the battery monitoring and/or state of discharge display apparatus (32); and in that a respective connection branch is selected by the connection of the relevant connection branch end associated with the battery connection part (16) to a first one (24) of the two main contacts (24, 26) of the battery connector part, or of the associated battery terminal (22), with in particular a further connection line (40) for the battery monitoring and/or state of discharge display apparatus (32) being connected with the main contact (26') of the vehicle connector part (18) associated with the second main contact (26) of the battery connector part (16).

2. Plug connector in accordance with claim 1, characterised in that the first main contact (24) of the battery connector part (16) is connected to the positive battery terminal (22) and its second main contact (26) is connected to the negative battery terminal (20).

3. Plug connector in accordance with claim 1 or claim 2, characterised in that the different impedance values of the connection branches (34, 34'; 36, 36') are determined by a different number of diodes (42) which are respectively connected in series in the transmission direction, with, in particular, four diodes (42) being arranged in a first connection branch (34, 34') and a single diode (42) being arranged in a further connection branch (36, 36').

4. Plug connector in accordance with one of the claims 1 to 3, characterised in that the different impedance values of the connection branches (34, 34'; 36, 36') are determined by the resistance value of Ohmic resistors.

5. Plug connector in accordance with one of the preceding claims, characterised in that the diodes (42) or resistors are connected after the pilot contacts (28', 30') of the vehicle connector part (18), with, in particular, either the diodes (42) or the resistors being integrated in the vehicle connector part (18), or the diodes (42) or resistors being connected after the vehicle connector part (18).

6. Plug connector in accordance with one of the claims 1 to 5, characterised in that the diodes (42) or resistors are connected in front of the pilot contacts (28, 30) of the battery connector part (16), with, in particular, either the diodes (42) or the resistors being integrated in the battery connector part (16), or the diodes (42) or resistors being connected in front of the battery connector part (16).

7. Plug connector in accordance with one of the preceding claims, characterised in that a fuse (42) is inserted into at least one of the connection lines (38, 40) leading to the battery monitoring and/or state of discharge display apparatus (32), with the fuse (42) in particular being integrated in the vehicle connector part (18).

8. Plug connector in accordance with one of the preceding claims, characterised in that the battery connector part (16) and the vehicle connector part (18) each have two pilot contacts (28, 30; 28', 30').

9. Plug connector in accordance with one of the preceding claims, characterised in that for the diodes (42) or resistors which are connected after the pilot contacts (28', 30') of the vehicle connector part (18) the respective pilot contact (28, 30) of the battery connector part (16) is connected via a conductive bridge or the like directly with the relevant main contact (24) of the battery connector part (16).

## Revendications

1. Connecteur enfichable pour la connexion d'une batterie d'automobile (12) en particulier avec le réseau de bord d'une automobile et un appareil de surveillance de batterie et/ou d'indication de l'état de décharge (32), avec un élément de connexion (16) de batterie du côté de la batterie formé par une fiche ou une prise, et un élément de connexion (18) d'automobile du côté de l'automobile formé par une prise ou une fiche, les deux éléments de connexion étant pourvus respectivement de deux contacts principaux (26, 26', 24, 24') pour le raccordement du réseau de bord aux deux bornes de batterie, caractérisé en ce que l'élément de connexion (16) de batterie présente plusieurs contacts pilotes (28, 30), auxquels est associé un nombre égal de contacts pilotes (28', 30') de l'élément de connexion (18) d'automobile, en ce que des paires de contacts pilotes (28,28'; 30,30') venant en contact l'une avec l'autre sont posées dans des dérivation de connexion (34, 34'; 36, 36'), qui présentent des valeurs d'impédance différentes pour la compensation de différentes tensions de décharge de types de batterie divers, en ce que toutes les dérivations de connexion associées à l'élément de connexion (18) d'automobile sont reliées à une ligne de raccordement (38) commune pour l'appareil de surveillance de batterie et/ou d'indication de l'état de décharge (32), et en ce qu'une dérivation de connexion respective est choisie par connexion de l'extrémité de la dérivation de connexion associée à l'élément de connexion (16) de batterie correspondant avec un premier (24) des deux contacts principaux (24, 26) de l'élément de connexion de batterie ou de la borne de batterie (22) associée, une autre ligne de raccordement (40) pour l'appareil de surveillance de batterie et/ou d'indication de l'état de décharge (32) étant reliée en particulier au contact principal (26') de l'élément de connexion (18) d'automobile associé au second contact principal (26) de l'élément de connexion (16) de batterie.

2. Connecteur enfichable selon la revendication 1, caractérisé en ce que le premier contact principal (24) de l'élément de connexion (16) de batterie est relié à la borne de batterie (22) positive et son second contact principal (26) est relié à la borne de batterie (20) négative.

3. Connecteur enfichable selon l'une ou l'autre des revendications 1 et 2, caractérisé en ce que les valeurs d'impédance différentes des dérivations de connexion (34,34'; 36,36') sont déterminées par un nombre différent de diodes (42) branchées les unes derrière les autres respectivement dans la direction de passage, quatre diodes (42) étant agencées en particulier dans une première dérivation de connexion (34, 34') et une seule diode (42) étant agencée dans une autre dérivation de connexion (36,36').

4. Connecteur enfichable selon l'une quelconque des revendications 1 à 3, caractérisé en ce que les différentes valeurs d'impédance des dérivations de connexion (34,34'; 36,36') sont déterminées par la valeur résistive de résistances ohmiques.

5. Connecteur enfichable selon l'une quelconque des revendications précédentes, caractérisé en ce que les diodes (42) ou résistances sont branchées derrière les contacts pilotes (28', 30') de l'élément de connexion (18) d'automobile, les diodes (42) ou résistances étant en particulier soit intégrées dans l'élément de connexion (18) d'automobile soit étant branchées derrière l'élément de connexion (18) d'automobile.

6. Connecteur enfichable selon l'une quelconque des revendications 1 à 5, caractérisé en ce que les diodes (42) ou résistances sont branchées avant les contacts pilotes (28, 30) de l'élément de connexion (16) de batterie, les diodes (42) ou résistances étant en particulier soit intégrées dans l'élément de connexion (16) de batterie soit étant branchées avant l'élément de connexion (16) de batterie.

7. Connecteur enfichable selon l'une quelconque des revendications précédentes, caractérisé en ce qu'un fusible (42) est placé au moins dans une ligne de raccordement (38, 40) menant à l'appareil de surveillance de batterie et/ou d'indication de l'état de décharge (32), le fusible (42) étant en particulier intégré dans l'élément de connexion (18) d'automobile.

8. Connecteur enfichable selon l'une quelconque des revendications précédentes, caractérisé en ce que l'élément de connexion (16) de batterie et l'élément de connexion (18) d'automobile présentent respectivement deux contacts pilotes (28, 30 ; 28', 30').

9. Connecteur enfichable selon l'une quelconque des revendications précédentes, caractérisé en ce que pour les diodes (42) ou résistances branchées derrière les contacts pilotes (28', 30') de l'élément de connexion (18) d'automobile, le contact pilote (28, 30) respectif de l'élément de connexion (16) de batterie est directement relié à un contact principal (24) de l'élément de connexion (16) de batterie par l'intermédiaire d'un pont conducteur ou similaire.
